# EUROPÄISCHE PATENTSCHRIFT

(11) **EP 2 571 828 B1**
(45) Veröffentlichungstag und Bekanntmachung des Hinweises auf die Patenterteilung: **25.09.2013**
(21) Anmeldenummer: 11807858.3
(22) Anmeldetag: 07.12.2011
(51) Int. Cl.: C04B 28/18, H01L 35/22, H01L 35/32

(54) **BAUELEMENT ZUR ERZEUGUNG VON THERMOELEKTRISCHEM STROM UND VERFAHREN ZU DESSEN HERSTELLUNG**
STRUCTURAL ELEMENT FOR GENERATING THERMOELECTRIC POWER AND METHOD FOR THE PRODUCTION THEREOF
COMPOSANT POUR LA PRODUCTION DE COURANT THERMOÉLECTRIQUE ET PROCÉDÉ DE FABRICATION DE CE COMPOSANT

(30) Priorität: 27.12.2010 DE 202010016971 U
(43) Veröffentlichungstag der Anmeldung: 27.03.2013
(73) Patentinhaber: Aiysh, Jehad, 58097 Hagen (DE)
(72) Erfinder: Aiysh, Jehad, 58097 Hagen (DE)
(74) Vertreter: Dörner, Kötter & Kollegen
(86) Internationale Anmeldenummer: PCT/EP2011/006139
(87) Internationale Veröffentlichungsnummer: WO 2012/089295

(56) Entgegenhaltungen:
- WO-A1-79/00626
- WO-A2-2009/030236
- DE-U1- 20 308 416
- DE-U1-202010 016 971
- US-A- 2 981 775
- GUERRERO V H ET AL: "Thermoelectric property tailoring by composite engineering", JOURNAL OF MATERIALS SCIENCE, SPRINGER NETHERLANDS, NL, Bd. 37, Nr. 19, 1. Oktober 2002 (2002-10-01), Seiten 4127-4136, XP002505017, ISSN: 0022-2461, DOI: 10.1023/A:1020083718789
- BAHAR D ET AL: "Thermoelectric behavior of carbon fiber reinforced lightweight concrete with mineral admixtures", NEW CARBON MATERIALS,, Bd. 23, Nr. 1, 1. März 2008 (2008-03-01), Seiten 21-24, XP022937746, ISSN: 1872-5805, DOI: 10.1016/S1872-5805(08)60009-8 [gefunden am 2008-03-01]

## Beschreibung

Die Erfindung betrifft ein thermoelektrisches Bauelement sowie ein Verfahren zur Herstellung eines thermoelektrischen Bauelementes.

Aufgrund des zunehmenden Bedarfs nach elektrischer Energie und der Endlichkeit fossiler Brennstoffe sowie dem Erfordernis, CO₂-Emissionen zu reduzieren, besteht das Bedürfnis, Energie aus regenerativen Energiequellen zu gewinnen. Hierzu bieten sich neben der Wind- und Wasserkraft insbesondere die natürliche Wärme aus der Sonnenenergie und Thermalquellen sowie die Industrieabwärme an. Die Umwandlung der Wärmeenergie in thermoelektrischen Strom ist seit langer Zeit als Seebeck Effekt bekannt.

Bei der Erzeugung von thermoelektrischem Strom werden Temperaturunterschiede zwischen zwei Metallen genutzt. Die Erzeugung des thermoelektrischen Stroms basiert auf dem Prinzip, dass sich Ladungsträger unter dem Einfluss eines Temperaturunterschiedes neu gruppieren. Durch die Neuordnung entsteht an den Kontakten der beiden Metalle eine elektrische Spannung, soweit zwischen den Kontakten Temperaturdifferenz herrscht. Dieses Phänomen findet beispielsweise Anwendung bei thermoelektrischen Elementen (sog. TE) und thermoelektrischen Generatoren (sog. TEGs).

In den vergangenen Jahren wurden zahlreiche Veröffentlichungen gemacht, die unterschiedliche Verfahren und Vorrichtungen zur Gewinnung von thermoelektrischem Strom beschrieben. Fast alle diese Veröffentlichungen basierten auf Halbleitertechnologie. Beispiele hierfür sind unter anderem aus der DE 102 31 445 A1, DE 102 30 080 A1, DE 102 32 445 A1, US 6, 300, 150 B1 und US 6, 396,191 B1 bekannt.

Weiterhin existieren viele Veröffentlichungen zu den verschiedenen Einsatzmöglichkeiten von herkömmlichen thermoelektrischen Elementen. Anwendungsbeispiele sind unter anderem aus der DE 101 24 623 A1, DE 199 46 806 A1, NL 1 020 485 C2 und WO 2009/030236 A2 bekannt. Die Veröffentlichung GUERRERO V H ET AL: "Thermoelectric property tailoring by composite engineering", JOURNAL OF MATERIALS SCIENCE, SPRINGER NETHERLANDS, NL, Bd. 37, Nr. 19, 1. Oktober 2002, Seiten 4127-4136, XP002505017, ISSN: 0022-2461, DOI: 10.1023/A:1020083718789 offenbart ein thermoelektrisches Bauelement zur Erzeugung von thermoelektrischem Strom, das aus mindestens zwei Schichten und aus zwei metallischen Elektrokontakten gebildet ist, wobei die Schichten unterschiedliche Mischungen aufweisen und ihre Mischungen Portlandzement und "silica fume" enthalten. Aufgrund ihres niedrigen Wirkungsgrads und ihrer hohen Herstellkosten sind herkömmliche thermoelektrische Elemente derzeit unwirtschaftlich, und ihr Einsatz ist bisher lediglich auf wenige Bereiche beschränkt. Um eine bessere Güteziffer zu erreichen, wird derzeit an thermoelektrischen Generatoren mit Nanostrukturen geforscht, was jedoch sehr aufwendig und damit teuer ist.

Allgemein nachteilig bei den bekannten thermoelektrischen Elementen bzw. Generatoren ist, dass zur Erzeugung des thermoelektrischen Stroms jeweils eine Vorrichtung erforderlich ist, um die herkömmlichen thermoelektrischen Elemente an den Wänden oder auf Freiflächen anbringen zu können. In Folge dessen ist ein zusätzlicher technischer und damit auch finanzieller Aufwand erforderlich, um den genannten thermoelektrischen Strom zu erzeugen.

Hier will die Erfindung Abhilfe schaffen. Der Erfindung liegt die Aufgabe zugrunde, die Erzeugung von thermoelektrischem Strom ohne zusätzliche Vorrichtungen und Generatoren erzeugen zu ermöglichen. Gemäß der Erfindung wird diese Aufgabe durch ein thermoelektrisches Bauelement zur Erzeugung von thermoelektrischem Strom nach Anspruch 1 gelöst, das aus mindestens zwei Schichten und aus zwei metallischen Elektrokontakten gebildet ist, wobei die Schichten unterschiedliche Mischungen aufweisen und ihre Mischungen Kalk und Quarzsand enthalten, wobei zwischen der Schichter ein Tuch angeordnet ist.

Mit der Erfindung ist thermoelektrisches Bauelement zur Erzeugung von thermoelektrischem Strom geschaffen, bei dem durch die Temperaturdifferenz zwischen den einzelnen Schichten thermoelektrische Spannung entsteht, die mit Hilfe von Metallkontakten an den freien Oberflächen des thermoelektrischen Bauelements abgenommen wird. Weiterhin schafft die Erfindung die Möglichkeit, thermoelektrischen Strom zu erzeugen, ohne hierzu zusätzliche Vorrichtungen anbringen zu müssen. Vielmehr bietet das erfindungsgemäße Bauelement die Möglichkeit, ein Gebäude aus einer Vielzahl von erfindungsgemäßen Bauelementen zu erstellen oder zu verkleiden und hierdurch direkt Strom zu erzeugen. Es ist daher nicht mehr erforderlich, an einem bestehenden Gebäude zusätzliche Vorrichtungen zur Erzeugung des thermoelektrischen Stroms anzubringen. Dies bietet die Möglichkeit einer erheblichen Kosteneinsparung, sodass die Nutzung des thermoelektrischen Stroms mit geringem finanziellem Aufwand flächendeckend möglich ist.

In Ausgestaltung der Erfindung sind die Schichten und das Tuch sandwichartig miteinander verbunden. Hierdurch ist gewährleistet, dass ein großflächiges thermoelektrisches Bauelement herstellbar ist.

Anwendungsbereiche der erfindungsgemäßen thermoelektrischen Bauelemente sind von der Stärke der metallischen Elektrokontakte sowie von der Stärke der Mischungsschichten abhängig. Das heißt, die erfindungsgemäßen thermoelektrischen Bauelemente können unter anderem als Fassadenverkleidung, als Wandelemente oder sogar als Tapeten hergestellt werden.

Die Aufgabe wird erfindungsgemäß zudem durch ein Verfahren zur Herstellung eines thermoelektrischen Bauelementes nach Anspruch 12 gelöst, bei dem eine erste Mischung für die erste Schicht aus Quarzsandpulver, Kalk, Tonerde, Fermit und Kalium sowie eine zweite Mischung für die zweite Schicht aus Quarzsandpulver, Kalk, Tonerde, Gips und Natrium erstellt wird, beide Mischungen anschließend jeweils mit Methylzellulose und Wasser zu einer teigartigen Masse verrührt werden, die erste Mischung der ersten Schicht auf ein Tuch dünn aufgetragen wird und auf der oberen, noch feuchten Schichtseite der Elektrokontakt des Minuspols angebracht wird, die zweite Mischung der zweiten Schicht auf die andere Seite des Tuches aufgetragen und darauf der Elektrokontakt des Pluspols angebracht wird und anschließend das Bauelement getrocknet wird.

Andere Weiterbildungen und Ausgestaltungen der Erfindung sind in den übrigen Unteransprüchen angegeben. Ein Ausführungsbeispiel der Erfindung ist in der Zeichnung dargestellt und wird nachfolgend im Einzelnen beschrieben. Es zeigen:

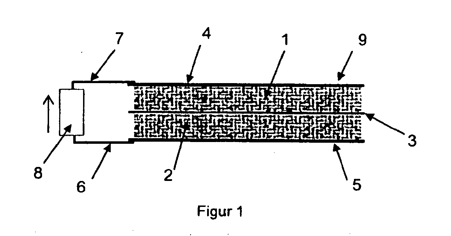

- Figur 1: die schematische Darstellung eines thermoelektrische Bauelements zur Erzeugung von thermoelektrischem Strom, angeschlossen an einem elektrischen Verbraucher.

Das erfindungsgemäße thermoelektrische Bauelement 9 zur Erzeugung von thermoelektrischem Strom ist aus mindestens zwei Schichten 1, 2 und aus zwei metallischen Elektrokontakten 4, 5 gebildet. Die Schichten 1, 2 weisen unterschiedliche Mischungen auf. Ihre Mischungen enthalten Kalk und Quarzsand. Die Schichten 1, 2 können darüber hinaus Bestandteile von Tonerde aufweisen. Um die zur Erstellung der Schichten 1, 2 notwendigen Stoffe eine zuverlässige Bindung eingehen zu lassen, können diese Methylzellulose-Anteile enthalten.

Die erste Schicht 1 kann zudem Fermit-Anteile, Kaliumanteile oder Kaliumchlorid enthalten. Die zweite Schicht 2 kann dagegen Natriumanteile, Natriumcarbonat-Anteile oder Gipsanteile aufweisen.

Im Ausführungsbeispiel ist zwischen den Schichten 1 und 2 ein Tuch 3 angeordnet. Die Schichten 1 und 2 und das Tuch 3 sind sandwichartig miteinander verbunden. Das Tuch 3 weist Viskoseanteile auf. In Abwandlung des Ausführungsbeispiels kann das Tuch 3 je nach Anwendungsfall auch Anteile von Wolle, Baumwolle und Zellulose enthalten.

An den Schichten 1 und 2 sind metallische Elektrokontakte 4, 5 angeordnet, an die elektrische Leitungen 6, 7 angeschlossen sind. Über die elektrischen Leitungen 6, 7 sind die Schichten 1 und 2 elektrisch miteinander verbunden. Zwischen den Leitungen 6, 7 ist ein Verbraucher 8 angeordnet.

Der Elektrokontakt 4 bildet den Minuspol, der Elektrokontakt 5 den Pluspol des Bauelements 9. Im Ausführungsbeispiel ist der Elektrokontakt 4 von einer Aluminiumplatte gebildet. In Abwandlung des Ausführungsbeispiels kann der Elektrokontakt 4 auch als Zinnplatte, Aluminiumfolie, Zinnfolie oder Stahlblech ausgebildet sein. Der Elektrokontakt 5 ist von einer Kupferfolie gebildet. Er kann aber auch aus Messing, Kupferfolie, Bronze oder Konstantan gebildet sein.

Durch Erwärmung der die Warmseite bildenden Schicht 1 bei gleichzeitig unveränderter oder auch durch zusätzliche Kühlung sinkender Temperatur der die Kaltseite bildenden Schicht 2 erfolgt eine Neugruppierung der Elektronen. Folglich weisen die Elektronen an der heißen Seite eine höhere Bewegungsenergie als die Elektronen an der kalten Seite des Bauelementes 9 auf. Die größere Bewegungsenergie bewirkt, dass sich die heißen Elektronen im Bauelement 9 stärker verteilen als die kalten. Auf diese Weise entsteht Ungleichgewicht, weil die Elektronendichte an der kalten Seite zunimmt. Dies geschieht so lange, bis die aufgebaute elektrische Spannung dafür sorgt, dass ein gleich großer Strom kalter Elektronen auf die heiße Seite fließt.

Aufgrund der isolierenden Wirkung des Tuchs 3 erfolgt gleichzeitig kein Wärmetransport von der Schicht 1 in Richtung der Schicht 2. Dadurch ist die Temperatur in der Schicht 2 nicht durch die Wärmeeinstrahlung auf die Schicht 1 beeinflusst. Dies ist von großem Vorteil, da die Temperaturdifferenz zwischen den Schichten 1 und 2 wesentlichen Einfluss auf die Leistungsfähigkeit bei der Gewinnung von Strom in dem erfindungsgemäßen Bauelement hat.

Das erfindungsgemäße thermoelektrische Bauelement 9 wird nach den folgenden Schritten hergestellt:
In der Vorbereitungsphase wird Methylzellulose (Tapetenkleister) mit Wasser in einer sauberen Schale verrührt bis sich eine zähflüssige klebrige Masse bildet. In einer zweiten Schale wird die erste Mischung für die erste Schicht 1 aus 45% Quarzsandpulver, 50% Kalk, 4% Tonerde, 0,5% Fermit und 0,5% Kalium zusammen nach und nach mit dem Tapetenkleister gemischt, bis sich eine teigartige Masse bildet. Als Ersatz für Kalium kann Kaliumchlorid genommen werden.

In einer dritten Schale wird die zweite Mischung für die zweite Schicht 2 aus 45% Quarzsandpulver, 50% Kalk, 4% Tonerde, 0,5% Gips und 0,5% Natrium zusammen nach und nach mit dem Tapetenkleister gemischt, bis sich eine teigartige Masse bildet. Als Ersatz für Natrium kann Natriumcarbonat (Soda) genommen werden. Bei den Mischungen ist zu beachten, dass es sich um Gewichtverhältnisse handelt.

Im zweiten Arbeitsgang wird die erste Mischung der ersten Schicht 1 auf ein dünnes Tuch 3 dünn aufgetragen. Auf der oberen, noch feuchten Schichtseite wird eine Metallplatte oder Metallfolie als Elektrokontakt 4 des Minuspols angebracht. Als Minuspolkontakt eignen sich neben Aluminium auch Stahlblech und Zinn.

Die zweite Mischung der zweiten Schicht 2 wird auf der anderen Seite des Tuches 3 dünn aufgetragen und darauf wird die Metallplatte oder Metallfolie aus Kupfer, Bronze, Messing oder Konstantan als Elektrokontakt 5 des Pluspols angebracht. An den beiden metallischen Elektrokontakten 4, 5 werden die elektrischen Leitungen 6, 7 angebracht. Mit Hilfe der elektrischen Leitungen 6, 7 können die einzelne thermoelektrische Bauelement mit einander in Reihe oder parallel geschaltet werden. Die elektrischen Leitungen 6, 7 können dann an ein elektrischer Verbraucher 8 angeschlossen werden.

Nach der Trocknungszeit von 1 bis 2 Tagen wird das thermoelektrische Bauelement 9 je nach Anwendungsbereich mit Isolierlack oder Kunstharz wasserdicht beschichtet.

## Patentansprüche

1. Thermoelektrisches Bauelement (9) zur Erzeugung von thermoelektrischem Strom, das aus mindestens zwei Schichten (1, 2) und aus zwei metallischen Elektrokontakten (4, 5) gebildet ist, wobei die Schichten (1, 2) unterschiedliche Mischungen aufweisen und ihre Mischungen Kalk und Quarzsand enthalten, **dadurch gekennzeichnet, dass** zwischen den Schichten (1, 2) ein Tuch (3) angeordnet ist.

2. Thermoelektrisches Bauelement nach Anspruch 1, **dadurch gekennzeichnet, dass** die Schichten (1, 2) Tonerde aufweisen.

3. Thermoelektrisches Bauelement nach Anspruch 1 oder 2, **dadurch gekennzeichnet, dass** die Schichten (1, 2) Methylzellulose-Anteile aufweisen.

4. Thermoelektrisches Bauelement nach einem oder mehreren der vorgenannten Ansprüche, **dadurch gekennzeichnet, dass** die erste Schicht (1) Fermit-Anteile aufweist.

5. Thermoelektrisches Bauelement nach einem oder mehreren der vorgenannten Ansprüche, **dadurch gekennzeichnet, dass** die erste Schicht (1) Kaliumanteile aufweist.

6. Thermoelektrisches Bauelement nach einem oder mehreren der vorgenannten Ansprüche, **dadurch gekennzeichnet, dass** die erste Schicht (1) Kaliumchlorid Anteile aufweist.

7. Thermoelektrisches Bauelement nach einem oder mehreren der vorgenannten Ansprüche, **dadurch gekennzeichnet, dass** die zweite Schicht (2) Natriumanteile aufweist.

8. Thermoelektrisches Bauelement nach einem oder mehreren der vorgenannten Ansprüche, **dadurch gekennzeichnet, dass** die zweite Schicht (2) Natriumcarbonat-Anteile aufweist.

9. Thermoelektrisches Bauelement nach einem oder mehreren der vorgenannten Ansprüche, **dadurch gekennzeichnet, dass** die zweite Schicht (2) Gipsanteile aufweist.

10. Thermoelektrisches Bauelement nach einem oder mehreren der vorgenannten Ansprüche, **dadurch gekennzeichnet, dass** die Schichten (1, 2) und das Tuch (3) sandwichartig miteinander verbunden sind.

11. Thermoelektrisches Bauelement nach einem oder mehreren der vorgenannten Ansprüche, **dadurch gekennzeichnet, dass** an den Schichten (1, 2) metallische Elektrokontakte (4, 5) angeordnet sind.

12. Verfahren zur Herstellung eines thermoelektrischen Bauelementes bei dem
- eine erste Mischung für die erste Schicht (1) aus Quarzsandpulver, Kalk, Tonerde, Fermit und Kalium oder Kaliumchlorid erstellt wird,
- eine zweite Mischung für die zweite Schicht (2) aus Quarzsandpulver, Kalk, Tonerde, Gips und Natrium, Natriumcarbonat oder Gips erstellt wird,
- beide Mischungen jeweils mit Methylzellulose und Wasser zu einer teigartigen Masse verrührt werden,
- die erste Mischung der ersten Schicht (1) auf ein Tuch (3) dünn aufgetragen wird und auf der oberen, noch feuchten Schichtseite der Elektrokontakt (4) des Minuspols angebracht wird,
- die zweite Mischung der zweiten Schicht (2) auf die andere Seite des Tuches (3) aufgetragen und darauf der Elektrokontakt (5) des Pluspols angebracht wird,
- und anschließend das Bauelement getrocknet wird.

13. Verfahren nach Anspruch 12, **dadurch gekennzeichnet, dass** an den beiden metallischen Elektrokontakten (4, 5) die elektrischen Leitungen (6, 7) angebracht werden.

14. Verfahren nach Anspruch 12 oder 13, **dadurch gekennzeichnet, dass** das Bauelement (9) wasserdicht beschichtet wird.

## Claims

1. Thermoelectric component (9) for the generation of thermoelectric current, which thermoelectric component (9) is formed of two or more layers (1, 2) and of two metal electrical contacts (4, 5), where the layers (1, 2) incorporate different mixtures and their mixtures contain lime and quartz sand, **characterised in that** a cloth (3) is disposed between the layers (1, 2).

2. Thermoelectric component in accordance with claim 1, **characterised in that** the layers (1, 2) incorporate alumina.

3. Thermoelectric component in accordance with claim 1 or 2, **characterised in that** the layers (1, 2) incorporate methyl cellulose content.

4. Thermoelectric component in accordance with any one or more of the aforementioned claims, **characterised in that** the first layer (1) incorporates Fermit content.

5. Thermoelectric component in accordance with any one or more of the aforementioned claims, **characterised in that** the first layer (1) incorporates potassium content.

6. Thermoelectric component in accordance with any one or more of the aforementioned claims, **characterised in that** the first layer (1) incorporates potassium chloride content.

7. Thermoelectric component in accordance with any one or more of the aforementioned claims, **characterised in that** the second layer (2) incorporates sodium content.

8. Thermoelectric component in accordance with any one or more of the aforementioned claims, **characterised in that** the second layer (2) incorporates sodium carbonate content.

9. Thermoelectric component in accordance with any one or more of the aforementioned claims, **characterised in that** the second layer (2) incorporates gypsum content.

10. Thermoelectric component in accordance with any one or more of the aforementioned claims, **characterised in that** the layers (1, 2) and the cloth (3) are joined together sandwich-fashion.

11. Thermoelectric component in accordance with any one or more of the aforementioned claims, **characterised in that** metal electrical contacts (4, 5) are disposed on the layers (1, 2).

12. Process for manufacturing a thermoelectric component, where
- a first mixture is manufactured for the first layer (1) from quartz sand powder, limestone, alumina, Fermit and potassium or potassium chloride,
- a second mixture is manufactured for the second layer (2) from quartz sand powder, limestone, alumina, gypsum and sodium, sodium carbonate or gypsum,
- each of the two mixtures is stirred together with methyl cellulose and water to form a doughlike mass,
- the first mixture of the first layer (1) is applied thinly to a cloth (3) and the electrical contact (4) of the negative pole is mounted on the upper, still wet side of the layer,
- the second mixture of the second layer (2) is applied to the other side of the cloth (3) and the electrical contact (5) of the positive pole is mounted on this other side (3),
- and the component is then dried.

13. Process in accordance with claim 12, **characterised in that** electrical leads (6, 7) are attached to the two metal electrical contacts (4, 5).

14. Process in accordance with claim 12 or 13, **characterised in that** the component (9) is coated watertightly.

## Revendications

1. Composant thermoélectrique (9) destiné à la production de courant électrique et composé d'au moins deux couches (1, 2) et de deux contacts électriques métalliques (4, 5), sachant que les couches (1, 2) présentent différents mélanges et que leurs mélanges contiennent du calcaire et du sable siliceux, **caractérisé en ce qu'**entre les couches (1, 2) est agencée une toile (3).

2. Composant thermoélectrique selon la revendication 1, **caractérisé en ce que** les couches (1, 2) présentent de l'alumine.

3. Composant thermoélectrique selon la revendication 1 ou 2, **caractérisé en ce que** les couches (1, 2) présentent des parts de méthylcellulose.

4. Composant thermoélectrique selon l'une ou plusieurs des revendications précédentes, **caractérisé en ce que** la première couche (1) présente des parts de fermite.

5. Composant thermoélectrique selon l'une ou plusieurs des revendications précédentes, **caractérisé en ce que** la première couche (1) présente des parts de potassium.

6. Composant thermoélectrique selon l'une ou plusieurs des revendications précédentes, **caractérisé en ce que** la première couche (1) présente des parts de chlorure de potassium.

7. Composant thermoélectrique selon l'une ou plusieurs des revendications précédentes, **caractérisé en ce que** la seconde couche (2) présente des parts de chlorure de sodium.

8. Composant thermoélectrique selon l'une ou plusieurs des revendications précédentes, **caractérisé en ce que** la seconde couche (2) présente des parts de carbonate de sodium.

9. Composant thermoélectrique selon l'une ou plusieurs des revendications précédentes, **caractérisé en ce que** la seconde couche (2) présente des parts de plâtre.

10. Composant thermoélectrique selon l'une ou plusieurs des revendications précédentes, **caractérisé en ce que** les couches (1,2) et la toile (3) sont reliées en sandwich entre elles.

11. Composant thermoélectrique selon l'une ou plusieurs des revendications précédentes, **caractérisé en ce que** des contacts électriques métalliques (4, 5) sont agencés sur les couches (1, 2).

12. Procédé pour fabriquer un composant thermoélectrique, au cours duquel
- on confectionne un premier mélange pour la première couche (1), composé de poudre de sable siliceux, de calcaire, d'alumine, de fermite et de potassium ou de chlorure de potassium,
- on confectionne un deuxième mélange pour la seconde couche (2), composé de poudre de sable siliceux, de calcaire, d'alumine, de plâtre et de sodium, de carbonate de sodium ou de plâtre,
- ces deux mélanges sont respectivement mélangés avec de la méthylcellulose et de l'eau pour former une masse pâteuse,
- le premier mélange de la première couche (1) est appliqué en couche mince sur une toile (3) et sur le côté supérieur de la couche encore humide est monté le contact électrique (4) du pôle moins,
- le second mélange de la seconde couche (2) est appliqué de l'autre côté de la toile (3), et sur cette couche est monté le contact électrique (5) du pôle plus,
- et ensuite le composant électrique est séché.

13. Procédé selon la revendication 12, **caractérisé en ce que** les fils électriques (6, 7) sont montés sur les deux contacts électriques métalliques (4, 5).

14. Procédé selon la revendication 12 ou 13, **caractérisé en ce que** le composant (9) reçoit un revêtement étanche à l'eau.
